# EUROPÄISCHE PATENTSCHRIFT

(11) **EP 4 388 204 B1**
(45) Veröffentlichungstag und Bekanntmachung des Hinweises auf die Patenterteilung: **13.11.2024**
(21) Anmeldenummer: 23732954.5
(22) Anmeldetag: 16.06.2023
(51) Int. Cl.: F04D 25/06, F04D 29/08, F04D 29/58, F04D 29/64, G06F 1/20, G06F 1/18

(54) **KÜHLVORRICHTUNG MIT EINEM LÜFTER UND GEHÄUSE MIT EINER SOLCHEN KÜHLVORRICHTUNG**
FAN, COOLING DEVICE WITH SUCH A FAN AND HOUSING WITH SUCH A COOLING DEVICE
VENTILATEUR, DISPOSITIF DE REFROIDISSEMENT DOTÉ D'UN TEL VENTILATEUR ET BOITIER DOTÉ D'UN TEL DISPOSITIF DE REFROIDISSEMENT

(30) Priorität: 17.06.2022 EP 22179505
(43) Veröffentlichungstag der Anmeldung: 26.06.2024
(73) Patentinhaber: FRONIUS INTERNATIONAL GmbH, 4643 Pettenbach (AT)
(72) Erfinder: MOSER, Peter, 4643 Pettenbach (AT); HUEMER, Bernhard, 4643 Pettenbach (AT)
(74) Vertreter: SONN Patentanwälte GmbH & Co KG
(86) Internationale Anmeldenummer: PCT/EP2023/066196
(87) Internationale Veröffentlichungsnummer: WO 2023/242382

(56) Entgegenhaltungen:
- EP-A2- 2 068 003
- AT-B1- 515 828
- DE-A1- 102018 207 985
- US-A- 5 437 327
- US-A1- 2013 248 155
- US-A1- 2018 103 559

## Beschreibung

Die Erfindung betrifft eine Kühlvorrichtung zur Kühlung in einem Gehäuse angeordneter leistungselektronischer Komponenten, mit einem Kühlkörper und mit einem Lüfter mit einem elektrischen Motor mit einem Rotor und mit dem Rotor drehfest verbundenen Rotorblättern, wobei der Motor in einem Motorgehäuse angeordnet und mit einem Kabel zur Versorgung mit elektrischer Energie verbunden ist, und der Kühlkörper eine Vielzahl an Kühlfinnen aufweist und eine Aussparung zur Aufnahme des Lüfters, wobei in der Aussparung des Kühlkörpers eine Vertiefung angeordnet ist, welche zur Aufnahme des Motorgehäuses des Lüfters ausgebildet ist.

Schließlich betrifft die Erfindung ein Gehäuse zur Aufnahme leistungselektronischer Komponenten, insbesondere ein Wechselrichtergehäuse, mit einer Gehäusefront und zumindest einem hinteren Gehäuseteil.

Insbesondere leistungselektronische Komponenten verschiedener elektronischer Vorrichtungen erzeugen Verlustwärme. Beispiele für solche Vorrichtungen sind Wechselrichter für Photovoltaikanlagen, Schweißstromquellen oder auch Batterieladegeräte. Um einen störungsfreien Betrieb solcher Geräte und eine hohe Lebensdauer zu gewährleisten, ist eine effiziente Abführung der Verlustwärme notwendig. Dies geschieht meist über Kühlkörper in Kombination mit Lüftern.

Beispielsweise beschreibt die AT 515 828 B1 eine Kühlvorrichtung zur Kühlung in einem Gehäuse angeordneter leistungselektronischer Komponenten und ein Wechselrichtergehäuse mit einer solchen Kühlvorrichtung, welche durch eine spezielle Anordnung eines Axiallüfters in einer Aussparung des Kühlkörpers mit speziell angeordneten Kühlfinnen eine verbesserte Kühlwirkung bei gleichzeitig platzsparendem und kompaktem Aufbau ermöglicht.

Auch die US 2018/0103559 A1 beschreibt eine Kühlvorrichtung der gegenständlichen Art.

Der Lüfter allenfalls zusammen mit einem Luftleitring zum Lenken der Kühlluft wird üblicherweise über mehrere Querstreben am Kühlkörper oder einem Gehäuseteil mit Hilfe von Schrauben befestigt. Zusätzlich wird meist das Kabel zur Versorgung des Motors des Lüfters mit elektrischer Energie entlang einer der Querstreben verlegt. Eine solche Konstruktion zeigt beispielsweise die US 2010/0051232 A1. Abgesehen vom hohen Montageaufwand erzeugen die Querstreben und allenfalls das Kabel beim Rotieren des Lüfters akustische Emissionen. Ähnlich einem Hubschrauberrotor, der beim Überstreichen der Heckkonstruktion des Hubschraubers für den Hubschrauber typische Geräusche erzeugt, entstehen bei einem üblichen Lüfter beim Überstreichen der Querstreben sogenannte Streichgeräusche. Um Störungen durch diese Schallemissionen zu vermeiden oder zumindest zu reduzieren, sind zusätzliche schalldämmende Maßnahmen erforderlich, welche sich wiederum negativ auf die Kühlung der leistungselektronischen Komponenten auswirken können.

Die Aufgabe der vorliegenden Erfindung besteht daher in der Schaffung einer oben genannten Kühlvorrichtung mit einem Lüfter und einem Gehäuse mit einer solchen Kühlvorrichtung, durch welche die vom Lüfter herrührenden akustischen Emissionen minimiert werden können. Gleichzeitig soll der Montageaufwand für den Lüfter möglichst gering gehalten werden. Nachteile bekannter Kühlvorrichtungen sollen vermieden oder zumindest reduziert werden.

Gelöst wird die erfindungsgemäße Aufgabe durch eine oben genannte Kühlvorrichtung, wobei das Motorgehäuse des Lüfters eine umlaufende Dichtung aufweist und an der den Rotorblättern abgewandten Seite des Motorgehäuses das Kabel sowie ein Befestigungselement angeordnet ist, wobei in der Vertiefung eine Aufnahme für das Befestigungselement und eine Durchführung für das Kabel angeordnet ist. Der Kühlkörper der Kühlvorrichtung besitzt somit in der Aussparung für den Lüfter eine Vertiefung, in welche das Motorgehäuse passt. Das am Motorgehäuse befindliche Befestigungselement wird in der in der Vertiefung angeordneten Aufnahme angeordnet und sorgt für die entsprechende Befestigung des Lüfters im Kühlkörper. Schließlich kann das ebenfalls an der Unterseite des Motorgehäuses angeordnete Kabel zur Versorgung des Motors des Lüfters mit elektrischer Energie durch die vorgesehene Durchführung in der Vertiefung des Kühlkörpers gefädelt werden, wodurch das Kabel von den Rotorblättern ferngehalten werden kann, wo es akustische Emissionen beim Überstreichen der Rotorblätter hervorrufen könnte. Somit kann der Lüfter ohne Querstreben oder andere Elemente, welche zu Streichgeräuschen führen könnten, rasch und einfach am Kühlkörper der Kühlvorrichtung befestigt werden. Beim Anordnen des Motorgehäuses in der Vertiefung der Aussparung des Kühlkörpers wird dieses gegenüber dem Kühlkörper durch die am Motorgehäuse vorgesehene Dichtung automatisch abgedichtet. Dadurch kann der Montage- und Demontageaufwand reduziert werden. Die oben erwähnten akustischen Emissionen durch das Streichen der Rotorblätter über Querstreben oder das Kabel können somit wirkungsvoll verhindert oder reduziert und die gesamten vom Lüfter herrührenden Schallemissionen reduziert werden. Darüber hinaus braucht das Kabel des Lüfters nicht über eine eigene Dichtung durch andere Bauteile, insbesondere den Kühlkörper, zu den entsprechenden elektronischen Komponenten geführt und abgedichtet werden, sondern dies geschieht an der den Rotorblättern abgewandten Seite des Motorgehäuses. Die gemäß der geforderten Schutzklasse häufig notwendige Abdichtung der zu kühlenden leistungselektronischen Komponenten von der Umgebung wird durch die im Motorgehäuse angeordnete umlaufende Dichtung weiter erzielt bzw. erleichtert. Die gegenständliche Kühlvorrichtung mit dem Lüfter ist einfach und kostengünstig herstellbar.

Vorzugsweise ist das Motorgehäuse des Lüfters im Wesentlichen zylindrisch ausgebildet. Dies erleichtert die Realisierung der Dichtung gegenüber dem Element, an dem der Lüfter montiert wird, also beispielsweise dem Kühlkörper und auch die Anordnung des Lüfters in einer entsprechend gestalteten Vertiefung in einer Aussparung des Elements, beispielsweise Kühlkörpers, da die Orientierung des Lüfters bzw. Motorgehäuses in Bezug auf die Vertiefung im Kühlkörper weitestgehend beliebig ist. Aber natürlich sind neben einer solchen zylindrischen Ausbildung auch andere unsymmetrische Formen des Motorgehäuses des Lüfters denkbar.

Die Dichtung des Motorgehäuses des Lüfters kann durch zumindest einen jeweils in einer Nut am vorzugsweise zylindrischen Motorgehäuse angeordneten O-Ring gebildet sein. Der O-Ring ist aus einem geeigneten elastischen Material, beispielsweise Silikon, gebildet. Die Dichtung gewährleistet die Abdichtung der elektronischen Elemente von der Umgebung beim Montieren des Lüfters insbesondere am Kühlkörper der Kühlvorrichtung.

Ebenso kann die Dichtung des Motorgehäuses des Lüfters durch zumindest eine Lamellendichtung am zylindrischen Motorgehäuse gebildet sein. Die Lamellendichtung ist aus einem geeigneten elastischen Kunststoff hergestellt. Wenn das Motorgehäuse des Lüfters aus Kunststoff besteht, kann die Lamellendichtung in besonders geeigneter Weise auch bereits bei der Herstellung des Motorgehäuses integriert werden und beispielsweise in einem Ein- oder Mehrkomponenten-Spritzgießverfahren hergestellt werden.

Das Befestigungselement am Motorgehäuse des Lüfters ist bevorzugter Weise durch eine Rastelement, vorzugsweise einen elastischen Rastzapfen, gebildet. Dadurch kann eine werkzeuglose Montage und vorzugsweise wieder Demontage des Lüfters von dem zu verbindenden Element, vorzugsweise dem Kühlkörper erzielt werden. Vorzugsweise ist das Befestigungselement durch einen elastischen Rastzapfen mit entsprechenden Widerhaken gebildet, welcher einfach und rasch in einer dafür vorgesehenen Bohrung angeordnet und verankert werden kann, indem der am Motorgehäuse angeordnete Rastzapfen durch die Bohrung gezogen wird, bis die Widerhaken entsprechend einrasten, sodass ein sicherer Halt des Lüfters im jeweiligen Element, vorzugsweise Kühlkörper, gewährleistet wird. Durch einen Druck auf den Rastzapfen in Richtung Motorgehäuse kann eine Lösung des Lüfters vom Kühlkörper vorzugsweise ohne die Verwendung eines Werkzeugs erzielt werden.

Ebenso kann das Befestigungselement durch eine Befestigungsschraube gebildet sein. Dies erhöht zwar den Aufwand bei der Montage und Demontage des Lüfters gegenüber einem oben erwähnten Rastelement, da auch ein entsprechendes Werkzeug, beispielsweise ein Schraubendreher, erforderlich ist. Im Gegensatz zu herkömmlichen Montagen über mehrere Befestigungsschrauben ist der Aufwand dennoch verringert, da nur eine Befestigungsschraube montiert oder demontiert werden muss. Durch die Anordnung der Befestigungsschraube am Motorgehäuse ist jedoch gewährleistet, dass die Montage des Lüfters zu keinen akustischen Emissionen beim Rotation der Rotorblätter führt.

Wenn das Kabel neben dem Befestigungselement angeordnet ist, kann dieses einfach neben dem Befestigungselement durch die entsprechend gestaltete Aufnahme für das Befestigungselement an jenem Element, an dem der Lüfter befestigt werden soll, insbesondere dem Kühlkörper, angeordnet werden. Bei einer Bohrung für die Aufnahme des Befestigungselements, insbesondere dem Rastzapfen, kann ein zusätzlicher Kanal für das Kabel neben der Bohrung platziert werden, sodass sich eine Aufnahme für das Befestigungselement und das Kabel in der Vertiefung des Kühlkörpers in Gestalt eines Schlüssellochs ergibt.

Vorzugsweise ist ein die Rotorblätter umgebender Luftleitring vorgesehen. Durch einen solchen üblicherweise zylindrischen Luftleitring kann die vom Lüfter, insbesondere Axiallüfter, angesaugte Kühlluft gezielt gelenkt werden und zu den maßgeblich zu kühlenden Bereichen des Kühlkörpers geleitet werden.

Die Aufnahme für das Befestigungselement ist vorzugsweise durch eine Bohrung gebildet. Eine solche Bohrung kann besonders rasch und einfach hergestellt werden und dient zur einfachen Aufnahme des durch ein Rastelement oder auch eine Befestigungsschraube gebildeten Befestigungselements am Motorgehäuse.

Auch die Durchführung für das Kabel ist vorzugsweise durch eine Bohrung gebildet, welche besonders rasch und einfach hergestellt werden kann. Die Durchführung für das Kabel und die Aufnahme für das Befestigungselement können auch gemeinsam hergestellt werden, sodass sich beispielsweise eine Öffnung für das Befestigungselement und das Kabel in Gestalt eines Schlüssellochs (siehe oben) ergibt.

Schließlich wird die erfindungsgemäße Aufgabe auch durch ein oben genanntes Gehäuse zur Aufnahme leistungselektronischer Komponenten, insbesondere ein Wechselrichtergehäuse, gelöst, wobei hinter der Gehäusefront eine oben genannte Kühlvorrichtung vorgesehen ist, wobei in der Gehäusefront eine Öffnung zum Ansaugen von Umgebungsluft angeordnet ist. Zu den dadurch erzielbaren Vorteilen wird auf die obige Beschreibungen des Lüfters und der Kühlvorrichtung verwiesen.

In der Öffnung der Gehäusefront kann ein Gitter oder ein anderer Schutz vor Berührung des Lüfters angeordnet sein. Anstelle eines Gitters oder dgl. kann die Zuführung der Kühlluft auch an hierfür geeigneten Stellen des Gehäuses erfolgen, wodurch vielleicht gar kein Gitter oder anderer Berührungsschutz notwendig ist.

Wenn der Luftleitring des Lüfters in der Gehäusefront angeordnet bzw. integriert ist, kann eine einfache und rasche Montage des Luftleitrings automatisch beim Zusammenbau des Gehäuses erzielt werden. Natürlich kann der Luftleitring auch durch einen eigenen Teil gebildet sein, der entsprechend um dem Lüfter angeordnet wird, um die Kühlluft entsprechend leiten zu können.

Die vorliegende Erfindung wird anhand der beigefügten Zeichnungen näher erläutert. Darin zeigen:
- Fig. 1: eine schematische Ansicht auf ein Gehäuse zur Aufnahme leistungselektronischer Komponenten;
- Fig. 2: eine Ansicht auf eine Kühlvorrichtung mit einem Lüfter zur Kühlung in einem Gehäuse angeordneter leistungselektronischer Komponenten nach dem Stand der Technik;
- Fig. 3: eine Ansicht auf den Kühlkörper einer Kühlvorrichtung, welcher zur Aufnahme eines Lüfters ausgebildet ist;
- Fig. 4: ein Schnittbild durch eine erste Ausführungsform einer erfindungsgemäßen Kühlvorrichtung;
- Fig. 5: eine Detailansicht des Motorgehäuses des Lüfters der Kühlvorrichtung im Bereich der Dichtung in zwei unterschiedlichen Ausführungsvarianten;
- Fig. 6: ein Schnittbild durch eine zweite Ausführungsform einer erfindungsgemäßen Kühlvorrichtung;
- Fig. 7: eine Seitenansicht auf einen Lüfter der Kühlvorrichtung; und
- Fig. 8: eine Ansicht von unten auf den Lüfter gemäß Fig. 7.

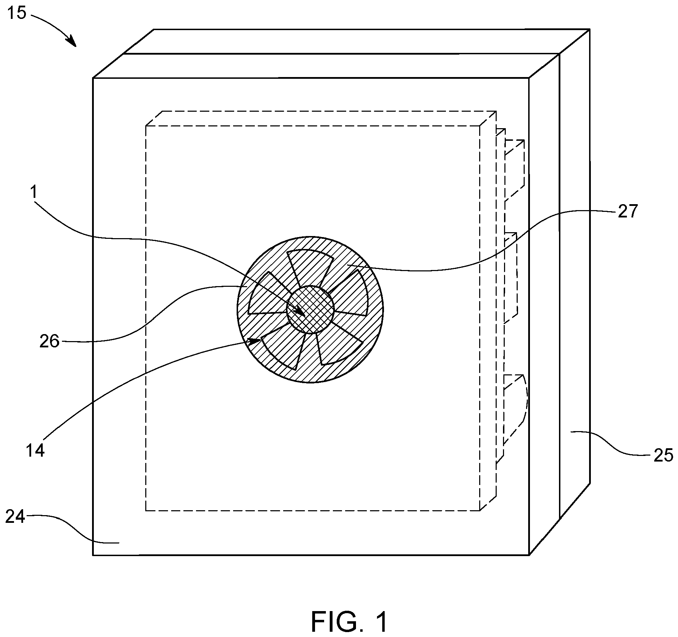

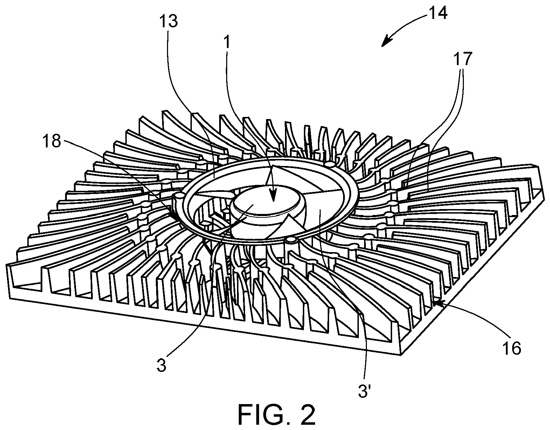

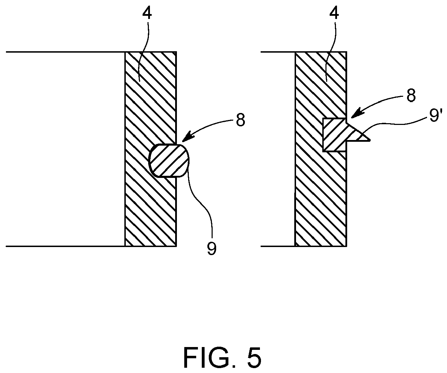

Fig. 1 zeigt eine schematische Ansicht auf ein Gehäuse 15 zur Aufnahme leistungselektronischer Komponenten, beispielsweise ein Wechselrichtergehäuse für den Wechselrichter einer Photovoltaikanlage. Das Gehäuse 15 besteht aus einem vorderen Teil, der Gehäusefront 24, und einem hinteren Gehäuseteil 25. Hinter der Gehäusefront 24 ist eine Kühlvorrichtung 14 (siehe Fig. 2) mit einem Lüfter 1 (siehe Fig. 5) angeordnet. In der Gehäusefront 24 ist eine Öffnung 26 zum Ansaugen von Umgebungsluft angeordnet. Vorzugsweise ist in der Öffnung 26 ein Gitter 27 oder ein anderer Berührungsschutz vorgesehen. Die Position der Öffnung 26 wird entsprechend an die hinter der Gehäusefront 24 angeordnete Kühlvorrichtung 14 angepasst. Insbesondere ist der Lüfter 1 der Kühlvorrichtung 14 hinter der Öffnung 26 angeordnet. Im dargestellten Beispiel ist die Öffnung 26 zentral an der Gehäusefront 24 angeordnet. Anstelle einer derartig über dem Lüfter 1 der Kühlvorrichtung 14 angeordneten Öffnung 26 können auch Schlitze oder dgl. an anderen Stellen der Gehäusefront 24 zum Ansaugen der Umgebungsluft platziert sein (nicht dargestellt). Hinter dem Kühlkörper 16 der Kühlvorrichtung 14 sind die zu kühlenden leistungselektronischen Komponenten angeordnet (nicht dargestellt bzw. nur mit den strichlierten Linien angedeutet). Die Kühlluft wird über geeignet angeordnete Schlitze oder dgl. in der Gehäusefront 24 oder dem hinteren Gehäuseteil 25 ausgeströmt (nicht dargestellt). Natürlich kann das Gehäuse 15 auch aus mehreren Gehäuseteilen bestehen und eine andere als die dargestellte quaderförmige Gestalt haben.

In Fig. 2 ist eine Ansicht auf eine Kühlvorrichtung 14 zur Kühlung in einem Gehäuse 15 (siehe Fig. 1) angeordneter leistungselektronischer Komponenten nach dem Stand der Technik gezeigt. Die Kühlvorrichtung 14 beinhaltet eine Kombination eines Kühlkörpers 16 mit integriertem Lüfter 1. Der Lüfter 1 ist in einer Aussparung 18 im Kühlkörper 16 angeordnet. Der Kühlkörper 16 umfasst eine Reihe von Kühlfinnen 17, welche hier im Wesentlichen radial um die Aussparung 18 für den Lüfter 1 angeordnet sind. Diese Anordnung bewirkt neben der Vergrößerung der Oberfläche eine Aufteilung des Kühlluftstroms und somit eine verbesserte Kühlwirkung. Der Lüfter 1 ist vorzugsweise an einer zentralen Stelle des Kühlkörpers 16 platziert, um eine gleichmäßige Verteilung der angesaugten Umgebungsluft über die gesamte Fläche des Kühlkörpers 16 zu erreichen. Üblicherweise ist um den Lüfter auch ein Luftleitring 13 angeordnet, wobei zwischen dessen Unterkante und der Grundfläche des Kühlkörpers 16 ein Zwischenraum gebildet ist. Dieser Zwischenraum ermöglicht es, dass der von oben angesaugte Luftstrom seitlich zwischen den Kühlfinnen 17 abgeführt werden kann. Üblicherweise wird der Lüfter 1 über Querstreben mit Hilfe entsprechender Befestigungsschrauben am Kühlkörper 16 befestigt. Ziehen die Rotorblätter 3 des Lüfters 1 im Betrieb desselben bei den Querstreben vorbei, entstehen störende akustische Emissionen, sogenannte Streichgeräusche, welche erfindungsgemäß vermieden oder zumindest reduziert werden sollen.

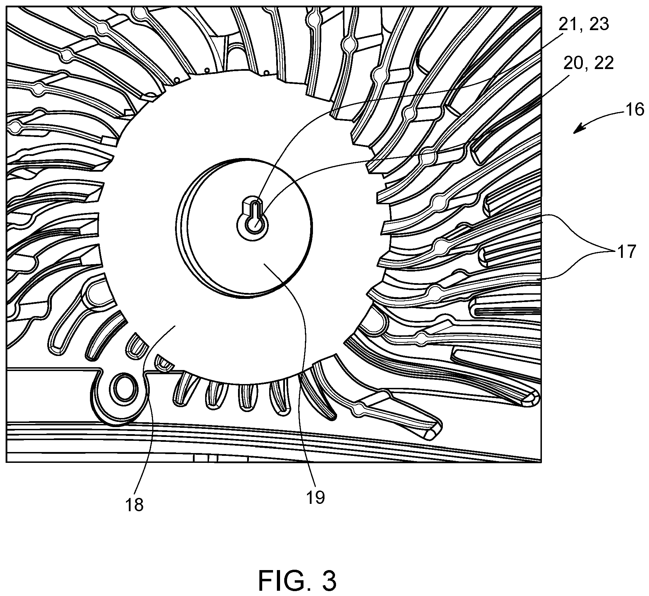

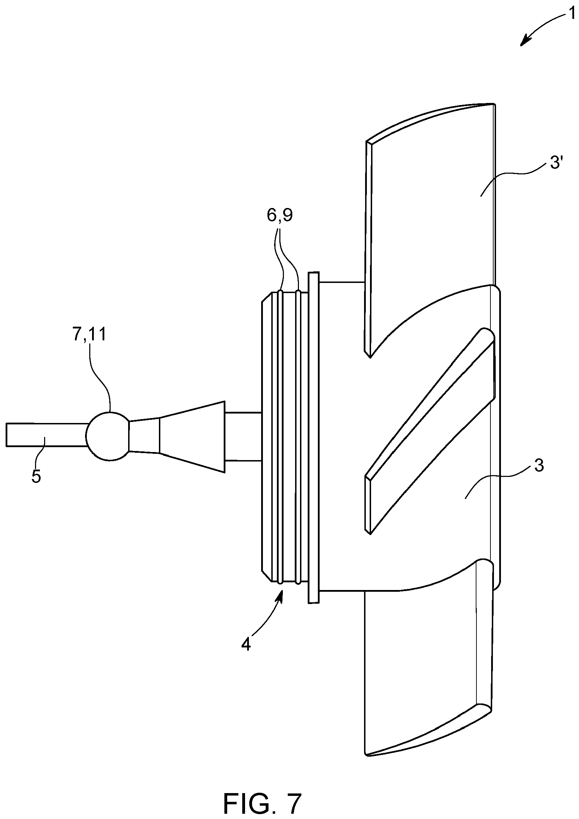

Fig. 3 zeigt eine Ansicht auf den Kühlkörper 16 einer Kühlvorrichtung 14, welcher zur Aufnahme eines Lüfters 1 (siehe Fig. 7) ausgebildet ist. Der Kühlkörper 16 weist eine Vielzahl an Kühlfinnen 17 und einer Aussparung 18 zur Aufnahme des Lüfters 1 (siehe Fig. 2) auf. In der Aussparung 18 des Kühlkörpers 16 ist eine Vertiefung 19 angeordnet, welche zur Aufnahme des Motorgehäuses 4 des Lüfters 1 ausgebildet ist. Bei einem zylinderförmigen Motorgehäuse 4 ist die Vertiefung 19 ebenfalls entsprechend zylinderförmig ausgeführt, sodass das Motorgehäuse 4 des Lüfters 1 darin aufgenommen und befestigt werden kann. Zur Befestigung des Lüfters 1 im Kühlkörper 16 ist in der Vertiefung 19 eine Aufnahme 20 für das Befestigungselement 7 des Lüfters 1 vorgesehen und weiters eine Durchführung 21 für das Kabel 5 des Lüfters 1 angeordnet. Vorzugsweise ist die Aufnahme 20 für das Befestigungselement 7 durch eine zylindrische Vertiefung 22 und die Durchführung 21 für das Kabel 5 durch eine Bohrung 23 gebildet. Wenn die zylindrische Vertiefung 22 und die Bohrung 23 unmittelbar nebeneinander bzw. übergehend angeordnet sind, resultiert eine Öffnung sowohl für das Befestigungselement 7 als auch das Kabel 5 des Lüfters 1 in Gestalt eines Schlüssellochs. Dadurch, dass sowohl die Befestigung des Lüfters 1 als auch die Durchführung des Kabels 5 nach unten durch den Kühlkörper 16 erfolgt, sind keine weiteren Befestigungselemente zur Befestigung des Lüfters 1 am Kühlkörper 16 notwendig und verläuft das Kabel 5 auch nicht in der Nähe der Rotorblätter 3 des Lüfters 1. Dadurch können Streichgeräusche beim Betrieb des Lüfters 1 vermieden und die akustischen Emissionen des Lüfters reduziert werden. Zusätzlich ist durch die Bauweise des Lüfters 1 einerseits und des Kühlkörpers 16 andererseits eine rasche und einfache Montage und Demontage des Lüfters 1 am Kühlkörper 16, vorzugsweise ohne Einsatz von Werkzeug, möglich.

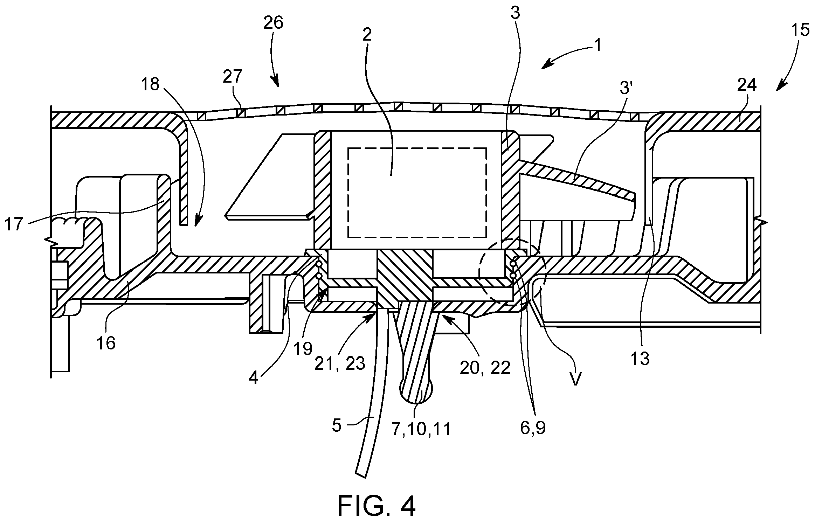

Fig. 4 gibt ein Schnittbild durch eine erste Ausführungsform einer erfindungsgemäßen Kühlvorrichtung 14 wieder. Das Motorgehäuse 4 des Lüfters 1 weist eine umlaufende Dichtung 6 in Form zweier in einer Nut 8 am Motorgehäuse 4 verlaufenden O-Ringe 9 auf (siehe Fig. 5, linkes Bild). An der den Rotorblättern 3' abgewandten Seite des Motorgehäuses 4 ist das Kabel 5 zur Versorgung des Motors 2 des Lüfters 1 mit elektrischer Energie sowie ein Befestigungselement 7 vorgesehen. Dieses Kabel 5 wird durch eine Durchführung 21 in der Vertiefung 19 des Kühlkörpers 16 hindurchgeführt. Diese Durchführung 21 ist vorzugsweise durch eine Bohrung 23 im Kühlkörper 16 gebildet. Das Motorgehäuse 4 ist bei diesem Ausführungsbeispiel zylindrisch ausgebildet. Dementsprechend ist die Vertiefung 19 in der Aussparung 18 des Kühlkörpers 16 der Kühlvorrichtung 14 ebenfalls zylinderförmig ausgebildet. Beim Einsetzen des Motorgehäuses 4 des Lüfters 1 in die Vertiefung 19 wird somit der Lüfter 1 automatisch zentriert. Das Befestigungselement 7 ist bei diesem Ausführungsbeispiel des Lüfters durch ein Befestigungselement 7 in Form eines Rastelements 10, vorzugsweise eines elastischen Rastzapfens 11, realisiert. In der Vertiefung 19 des Kühlkörpers 16 ist die Aufnahme 20 für das Befestigungselement 7 in Form einer zylindrischen Vertiefung 22 vorgesehen, durch welche zylindrische Vertiefung 22 der elastische Rastzapfen 11 zur Befestigung des Lüfters 1 am Kühlkörper 16 gezogen wird. Dies ermöglicht eine einfache und rasche werkzeuglose Befestigung des Lüfters 1 am Kühlkörper 16. Zur Demontage wird der elastische Rastzapfen 11 in Richtung des Motorgehäuses 4 des Lüfters 1 durch die zylindrische Vertiefung 22 bewegt und somit der Lüfter 1 vom Kühlkörper 16 gelöst.

Ein die Rotorblätter 3' des Lüfters 1 umgebender Luftleitring 13 dient zur Leitung des Kühlluftstroms. Der Luftleitring 13 kann als gesonderter Teil ausgebildet und in geeigneter Weise am Kühlkörper 16 befestigt, beispielsweise eingeschnappt, werden oder mit der Gehäusefront 24 des Gehäuses 15 verbunden oder in der Gehäusefront 24 integriert oder mitgefertigt sein. In letzterem Fall wird der Luftleitring 13 automatisch beim Schließen des Gehäuses 15 um dem Lüfter 1 platziert, sodass der Kühlluftstrom entsprechend gelenkt werden kann.

Fig. 5 zeigt eine Detailansicht des Motorgehäuses 4 des Lüfters 1 im Bereich der Dichtung 6 entsprechend dem Bereich V in Fig. 4 in zwei unterschiedlichen Ausführungsvarianten. Im linken Bild ist die Dichtung 6 des Motorgehäuses 4 des Lüfters durch einen in einer umlaufenden Nut 8 des Motorgehäuses 4 verlaufenden O-Ring 9 gebildet. Es können auch mehrere O-Ringe 9 nebeneinander oder untereinander in mehreren Nuten 8 im Motorgehäuse 4 des Lüfters 1 angeordnet werden. Bei der Ausführungsform im rechten Teil der Figur 5 ist die Dichtung 6 durch zumindest eine Lamellendichtung 9' am Motorgehäuse 4 gebildet. Die Lamellendichtung 9' kann in einer Nut 8 oder dgl. im Motorgehäuse 4 angeordnet sein oder auch direkt mit dem Motorgehäuse, beispielsweise in einem Ein- oder Mehrkomponenten-Spritzgießverfahren hergestellt sein.

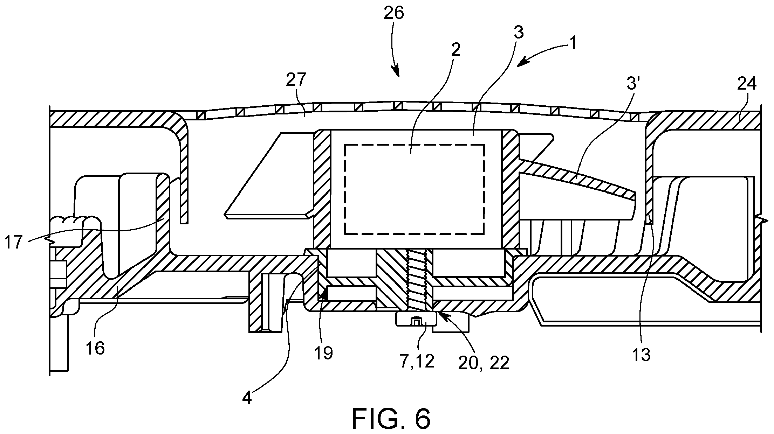

Schließlich zeigt Fig. 6 ein Schnittbild durch eine zweite Ausführungsform einer erfindungsgemäßen Kühlvorrichtung 14. Im Gegensatz zur Ausführungsform gemäß Fig. 4 ist hier das Befestigungselement 7 zur Befestigung des Motorgehäuses 4 des Lüfters 1 am Kühlkörper 16 durch eine Befestigungsschraube 12 gebildet, welche durch die zylindrische Vertiefung 22 des Kühlkörpers 16 geschraubt wird. Im Gegensatz zur Variante gemäß Fig. 4 wird hier ein Werkzeug zur Befestigung und Demontage des Lüfters 1 am bzw. vom Kühlkörper 16 benötigt.

Fig. 7 zeigt eine Seitenansicht auf einen Lüfter 1 der Kühlvorrichtung 14. Der Lüfter 1 besitzt einen elektrischen Motor 2 (nicht dargestellt), einen Rotor 3 und mit dem Rotor 3 drehfest verbundene Rotorblätter 3'. Der Lüfter 1 weist weiters ein bevorzugt zylindrisch ausgebildetes Motorgehäuse 4 auf und ein Kabel 5 zur Versorgung des Motors 2 mit elektrischer Energie. Das Motorgehäuse 4 weist eine umlaufende Dichtung 6 auf, welche hier durch zwei O-Ringe 9 gebildet ist. An der den Rotorblättern 3' abgewandten Seite des Motorgehäuses 4 ist das Kabel 5 sowie ein Befestigungselement 7 angeordnet. Im dargestellten Ausführungsbeispiel des Lüfters 1 ist das Befestigungselement 7 durch einen elastischen Rastzapfen 11 gebildet.

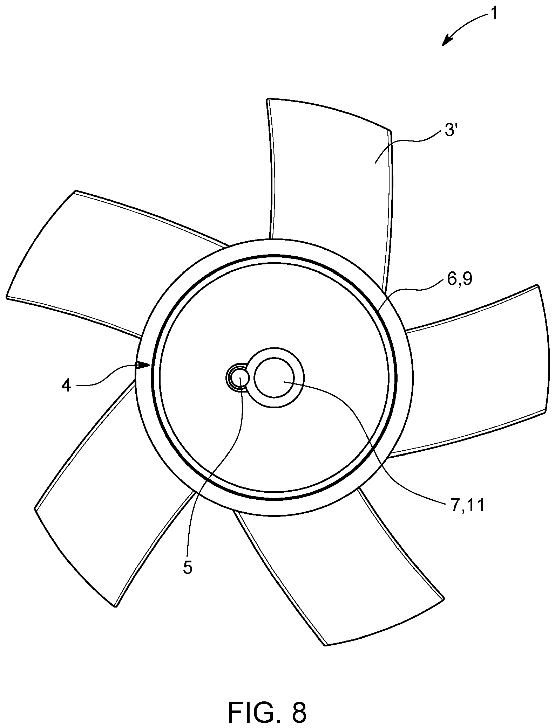

In Fig. 8 ist eine Ansicht von unten auf den Lüfter 1 gemäß Fig. 7 dargestellt. Hier ist das zylindrische Motorgehäuse 4 erkennbar und das an der Unterseite bzw. den Rotorblättern 3' abgewandten Seite angeordnete Kabel 5 und das als elastisches Rastelement 11 gebildete Befestigungselement 7 dargestellt.

Bei der erfindungsgemäß ausgebildeten Kühlvorrichtung 14 (siehe Fig. 4) ist der Lüfter 1 besonders einfach und rasch an dem entsprechenden Kühlkörper 16 montierbar und es werden durch Befestigungselemente oder dgl. hervorgerufene Streichgeräusche vermieden oder zumindest reduziert.

## Patentansprüche

1. Kühlvorrichtung (14) zur Kühlung in einem Gehäuse (15) angeordneter leistungselektronischer Komponenten, mit einem Kühlkörper (16) und mit einem Lüfter (1) mit einem elektrischen Motor (2) mit einem Rotor (3) und mit dem Rotor (3) drehfest verbundenen Rotorblättern (3'), wobei der Motor (2) in einem Motorgehäuse (4) angeordnet und mit einem Kabel (5) zur Versorgung mit elektrischer Energie verbunden ist, und der Kühlkörper (16) eine Vielzahl an Kühlfinnen (17) aufweist und eine Aussparung (18) zur Aufnahme des Lüfters (1), wobei in der Aussparung (18) des Kühlkörpers (16) eine Vertiefung (19) angeordnet ist, welche zur Aufnahme des Motorgehäuses (4) des Lüfters (1) ausgebildet ist, **dadurch gekennzeichnet, dass** das Motorgehäuse (4) des Lüfters (1) eine umlaufende Dichtung (6) aufweist und an der den Rotorblättern (3') abgewandten Seite des Motorgehäuses (4) das Kabel (5) sowie ein Befestigungselement (7) angeordnet ist, wobei in der Vertiefung (19) eine Aufnahme (20) für das Befestigungselement (7) und eine Durchführung (21) für das Kabel (5) angeordnet ist.

2. Kühlvorrichtung (14) nach Anspruch 1, **dadurch gekennzeichnet, dass** das Motorgehäuse (4) des Lüfters (1) im Wesentlichen zylindrisch ausgebildet ist.

3. Kühlvorrichtung (14) nach Anspruch 1 oder 2, **dadurch gekennzeichnet, dass** die Dichtung (6) des Motorgehäuses (4) des Lüfters (1) durch zumindest einen jeweils in einer Nut (8) am vorzugsweise zylindrischen Motorgehäuse (4) angeordneten O-Ring (9) gebildet ist.

4. Kühlvorrichtung (14) nach Anspruch 1 oder 2, **dadurch gekennzeichnet, dass** die Dichtung (6) des Motorgehäuses (4) des Lüfters (1) durch zumindest eine Lamellendichtung (9') am Motorgehäuse (4) gebildet ist.

5. Kühlvorrichtung (14) nach einem der Ansprüche 1 bis 4, **dadurch gekennzeichnet, dass** das Befestigungselement (7) durch eine Rastelement (10), vorzugsweise einen elastischen Rastzapfen (11), gebildet ist.

6. Kühlvorrichtung (14) nach einem der Ansprüche 1 bis 4, **dadurch gekennzeichnet, dass** das Befestigungselement (7) durch eine Befestigungsschraube (12) gebildet ist.

7. Kühlvorrichtung (14) nach einem der Ansprüche 1 bis 5, **dadurch gekennzeichnet, dass** das Kabel (5) neben dem Befestigungselement (7) angeordnet ist.

8. Kühlvorrichtung (14) nach einem der Ansprüche 1 bis 7, **dadurch gekennzeichnet, dass** ein die Rotorblätter (3') umgebender Luftleitring (13) vorgesehen ist.

9. Kühlvorrichtung (14) nach einem der Ansprüche 1 bis 8, **dadurch gekennzeichnet, dass** die Aufnahme (20) für das Befestigungselement (7) durch eine zylindrische Vertiefung (22) gebildet ist.

10. Kühlvorrichtung (14) nach einem der Ansprüche 1 bis 9, **dadurch gekennzeichnet, dass** die Durchführung (21) für das Kabel (5) durch eine Bohrung (23) gebildet ist.

11. Gehäuse (15) zur Aufnahme leistungselektronischer Komponenten, insbesondere Wechselrichtergehäuse, mit einer Gehäusefront (24) und zumindest einem hinteren Gehäuseteil (25), **dadurch gekennzeichnet, dass** hinter der Gehäusefront (24) eine Kühlvorrichtung (14) nach einem der Ansprüche 1 bis 10 vorgesehen ist, wobei in der Gehäusefront (24) eine Öffnung (26) zum Ansaugen von Umgebungsluft angeordnet ist.

12. Gehäuse (15) nach Anspruch 11, **dadurch gekennzeichnet, dass** in der Öffnung (26) der Gehäusefront (24) ein Gitter (27) angeordnet ist.

13. Gehäuse (15) nach Anspruch 11 oder 12, **dadurch gekennzeichnet, dass** in der Gehäusefront (24) der Luftleitring (13) des Lüfters (1) angeordnet ist.

## Claims

1. A cooling device (14) for cooling power electronics components arranged in a housing (15), comprising a heat sink (16) and a fan (1) having an electric motor (2) with a rotor (3) and rotor blades (3') connected to the rotor (3) in a torque-proof manner, wherein the motor (2) is arranged in a motor housing (4) and is connected to a cable (5) for the supply of electrical energy, and the heat sink (16) has a plurality of cooling fins (17) and a cavity (18) for receiving the fan (1), wherein a recess (19), which is designed for receiving the motor housing (4) of the fan (1) is arranged in the cavity (18) of the heat sink (16), **characterised in that** the motor housing (4) of the fan (1) has a peripheral seal (6) and the cable (5) and a fastening element (7) are arranged on the side of the motor housing (4) facing away from the rotor blades (3'), wherein a receptacle (20) for the fastening element (7) and a feed-through (21) for the cable (5) are arranged in the recess (19).

2. The cooling device (14) according to claim 1, **characterised in that** the motor housing (4) of the fan (1) is substantially of cylindrical design.

3. The cooling device (14) according to claim 1 or 2, **characterised in that** the seal (6) of the motor housing (4) of the fan (1) is formed by at least one O-ring (9) arranged in each case in a groove (8) on the preferably cylindrical motor housing (4).

4. The cooling device (14) according to claim 1 or 2, **characterised in that** the seal (6) of the motor housing (4) of the fan (1) is formed by at least one lamellar seal (9') on the motor housing (4).

5. The cooling device (14) according to any of claims 1 to 4, **characterised in that** the fastening element (7) is formed by a latching element (10), preferably an elastic latching pin (11).

6. The cooling device (14) according to any of claims 1 to 4, **characterised in that** the fastening element (7) is formed by a fastening screw (12).

7. The cooling device (14) according to any of claims 1 to 5, **characterised in that** the cable (5) is arranged next to the fastening element (7).

8. The cooling device (14) according to any one of claims 1 to 7, **characterised in that** an air guide ring (13) surrounding the rotor blades (3') is provided.

9. The cooling device (14) according to any of claims 1 to 8, **characterised in that** the receptacle (20) for the fastening element (7) is formed by a cylindrical recess (22).

10. The cooling device (14) according to any of claims 1 to 9, **characterised in that** the feed-through (21) for the cable (5) is formed by a bore (23).

11. A housing (15) for receiving power electronics components, in particular inverter housing, having a housing front (24) and at least one rear housing part (25), **characterised in that** a cooling device (14) according to any of claims 1 to 10 is provided behind the housing front (24), wherein an opening (26) for sucking in ambient air is arranged in the housing front (24).

12. The housing (15) according to claim 11, **characterised in that** a grille (27) is arranged in the opening (26) of the housing front (24) .

13. The housing (15) according to claim 11 or 12, **characterised in that** the air guide ring (13) of the fan (1) is arranged in the housing front (24).

## Revendications

1. Dispositif de refroidissement (14) pour refroidir des composants électroniques de puissance agencés dans un boîtier (15), avec un dissipateur thermique (16) et un ventilateur (1) avec un moteur électrique (2) avec un rotor (3) et avec des pales de rotor (3') reliées de manière fixe en rotation au rotor (3), le moteur (2) étant agencé dans un boîtier de moteur (4) et étant relié à un câble (5) pour fournir de l'énergie électrique, et le dissipateur thermique (16) présentant plusieurs ailettes de refroidissement (17) et un évidement (18) pour recevoir le ventilateur (1), une cavité (19) étant agencée dans l'évidement (18) du dissipateur thermique (16), qui est conçue pour recevoir le boîtier du moteur (4) du ventilateur (1), **caractérisé en ce que** le boîtier du moteur (4) du ventilateur (1) présente un joint circonférentiel (6) et le câble (5) ainsi qu'un élément de fixation (7) sont agencés sur le côté du boîtier du moteur (4) opposé aux pales du rotor (3'), un logement (20) pour l'élément de fixation (7) et une conduite (21) pour le câble (5) étant agencés dans la cavité (19).

2. Dispositif de refroidissement (14) selon la revendication 1, **caractérisé en ce que** le boîtier du moteur (4) du ventilateur (1) est essentiellement cylindrique.

3. Dispositif de refroidissement (14) selon la revendication 1 ou 2, **caractérisé en ce que** le joint (6) du boîtier du moteur (4) du ventilateur (1) est formé par au moins un joint torique (9) agencé dans une rainure (8) sur le boîtier du moteur (4), de préférence cylindrique.

4. Dispositif de refroidissement (14) selon la revendication 1 ou 2, **caractérisé en ce que** le joint (6) du boîtier du moteur (4) du ventilateur (1) est formé par au moins un joint à lamelles (9') sur le boîtier du moteur (4).

5. Dispositif de refroidissement (14) selon l'une des revendications 1 à 4, **caractérisé en ce que** l'élément de fixation (7) est formé par un élément de crantage (10), de préférence un cran d'arrêt élastique (11).

6. Dispositif de refroidissement (14) selon l'une des revendications 1 à 4, **caractérisé en ce que** l'élément de fixation (7) est formé par une vis de fixation (12).

7. Dispositif de refroidissement (14) selon l'une des revendications 1 à 5, **caractérisé en ce que** le câble (5) est agencé à côté de l'élément de fixation (7).

8. Dispositif de refroidissement (14) selon l'une des revendications 1 à 7, **caractérisé en ce qu'**il est prévu un anneau de guidage d'air (13) entourant les pales du rotor (3').

9. Dispositif de refroidissement (14) selon l'une des revendications 1 à 8, **caractérisé en ce que** le logement (20) pour l'élément de fixation (7) est formé par un évidement cylindrique (22).

10. Dispositif de refroidissement (14) selon l'une des revendications 1 à 9, **caractérisé en ce que** la conduite (21) pour le câble (5) est formée par un alésage (23).

11. Boîtier (15) pour recevoir des composants électroniques de puissance, en particulier un boîtier d'onduleur, avec une partie frontale du boîtier (24) et au moins une partie arrière du boîtier (25) du boîtier, **caractérisé en ce qu'**un dispositif de refroidissement (14) selon l'une des revendications 1 à 10 est prévu derrière la partie frontale du boîtier (24), une ouverture (26) pour aspirer l'air ambiant étant agencée dans la partie frontale (24) du boîtier.

12. Boîtier (15) selon la revendication 11, **caractérisé en ce qu'**une grille (27) est agencée dans l'ouverture (26) de la partie frontale (24) du boîtier.

13. Boîtier (15) selon la revendication 11 ou 12, **caractérisé en ce que** l'anneau de guidage d'air (13) du ventilateur (1) est agencé dans la partie frontale (24) du boîtier.
